# FASCICULE DE BREVET EUROPEEN

(11) **EP 2 900 403 B1**
(45) Date de publication et mention de la délivrance du brevet: **23.05.2018**
(21) Numéro de dépôt: 13773301.0
(22) Date de dépôt: 16.09.2013
(51) Int. Cl.: B22D 27/04

(54) **MOULE CARAPACE A ECRAN THERMIQUE**
HÜLLENFORM MIT HITZESCHILD
SHELL MOULD HAVING A HEAT SHIELD

(30) Priorité: 25.09.2012 FR 1258966
(43) Date de publication de la demande: 05.08.2015
(73) Titulaire: SNECMA, 75015 Paris (FR)
(72) Inventeur: FARGEAS, Serge, F-77550 Mosisy-Cramayel Cedex (FR); COYEZ, Dominique, F-77550 Mosisy-Cramayel Cedex (FR)
(74) Mandataire: Calvo de Nó, Rodrigo
(86) Numéro de dépôt international: PCT/FR2013/052113
(87) Numéro de publication internationale: WO 2014/049223

(56) Documents cités:
- EP-A1- 1 452 251
- FR-A1- 2 874 340

## Description

### Arrière-plan de l'invention

La présente invention concerne le domaine de la fonderie, et plus particulièrement un moule carapace, ainsi que des procédés de fabrication et d'utilisation d'un tel moule carapace.

Des procédés de fonderie dits à cire perdue ou à modèle perdu sont connus depuis l'antiquité. Ils sont particulièrement adaptés pour la production de pièces métalliques avec des formes complexes. Ainsi, la fonderie à modèle perdu est notamment utilisée pour la production d'aubes de turbomachines.

Dans la fonderie à modèle perdu, la première étape est normalement la réalisation d'un modèle en matériau à température de fusion comparativement peu élevée, comme par exemple une cire ou résine, sur laquelle est ensuite surmoulé un moule. Après évacuation du matériau du modèle de l'intérieur du moule, ce qui donne son nom à ces procédés, un métal en fusion est coulé dans ce moule, afin de remplir la cavité formée par le modèle dans le moule après son évacuation. Une fois que le métal se refroidit et solidifie, le moule peut être ouvert ou détruit afin de récupérer une pièce métallique conforme à la forme du modèle.

Afin de pouvoir produire plusieurs pièces simultanément, il est possible de réunir plusieurs modèles dans une seule grappe dans laquelle ils sont reliés par un arbre formant, dans le moule, des canaux de coulée pour le métal en fusion.

Parmi les différents types de moules pouvant être utilisés dans la fonderie à modèle perdu, on connaît notamment les moules dits moules carapace, formés par trempage du modèle ou de la grappe de modèles dans une barbotine, suivi d'un saupoudrage du modèle ou de la grappe enduits de barbotine avec du sable réfractaire pour former une carapace autour du modèle ou de la grappe, et de la cuisson de cette carapace pour solidifier la barbotine de manière à consolider l'ensemble. Plusieurs trempages et saupoudrages successifs peuvent être envisagés afin d'obtenir une carapace d'une épaisseur suffisante avant sa cuisson. On entend par « sable réfractaire », dans le présent contexte, tout matériau granulaire avec une granularité suffisamment fine pour satisfaire aux tolérances de production souhaitées, capable de résister, à l'état solide, les températures du métal en fusion, et pouvant être consolidé en une seule pièce solide par la barbotine lors de la cuisson de la carapace.

On entend par « métal », dans le présent contexte, tant des métaux purs que des alliages métalliques, et notamment des alliages métalliques dits monocristallins tels qu'ont été développés depuis la fin des années 1970 afin de permettre la production en fonderie de pièces formées par un seul grain. Les alliages métalliques traditionnels sont polycristallins équiaxes : à l'état solide, ils forment une pluralité de grains de taille sensiblement identique, typiquement de l'ordre de 1 mm, mais d'orientation plus ou moins aléatoire. Les joints entre grains constituent des points faibles dans une pièce métallique produite en un tel alliage. L'utilisation d'additifs pour renforcer ces joints inter-grains présente toutefois le défaut de réduire la température du point de fusion, ce qui est un inconvénient particulièrement quand les pièces ainsi produites sont destinées à être utilisées à haute température. Typiquement, les alliages monocristallins sont des alliages de nickel avec une concentration de titane et/ou d'aluminium inférieure à 10% molaire. Ainsi, après leur solidification, ces alliages forment des solides biphasiques, avec une première phase *γ* et une deuxième phase *γ'.* La phase *γ* présente un réseau cristallin cubique à face centrée, dans lequel les atomes de nickel, aluminium et/ou titane peuvent occuper n'importe quelle des positions. Par contre, dans la phase *γ'*, les atomes d'aluminium et/ou titane forment une configuration cubique, occupant les huit coins du cube, tandis que des atomes de nickel occupent les faces du cube.

Un de ces alliages est l'alliage de nickel « AM1 » développé conjointement par la SNECMA et les laboratoires de l'ONERA, l'Ecole des Mines de Paris, et IMPHY SA. Les pièces produites en un tel alliage peuvent atteindre non seulement des tenues mécaniques particulièrement élevées dans tous les axes d'effort, mais aussi une tenue thermique améliorée, puisqu'on peut se passer des additifs destinés à lier plus fortement entre eux les grains cristallins. Ainsi, des pièces métalliques produites à base de tels alliages monocristallins peuvent être avantageusement utilisées, par exemple, dans les parties chaudes de turbines.

Néanmoins, afin de profiter pleinement des avantages des alliages monocristallins pour obtenir des propriétés thermomécaniques particulièrement avantageuses dans une pièce produite par fonderie, il peut être souhaitable d'assurer une solidification dirigée du métal dans le moule. On entend par « solidification dirigée », dans le présent contexte, comme la maîtrise de la germination et croissance de cristaux solides dans le métal en fusion lors de son passage de l'état liquide à l'état solide. L'objet d'une telle solidification dirigée est celui d'éviter les effets négatifs des joints de grains dans la pièce. Ainsi, la solidification dirigée peut être colonnaire ou monocristalline. La solidification dirigée colonnaire consiste à orienter tous les joints de grains dans une même direction, de manière à ce qu'ils ne puissent pas contribuer à la propagation de fissures. La solidification dirigée monocristalline consiste à assurer la solidification de la pièce en un seul cristal, de manière à supprimer totalement les joints de grains.

Le fascicule de publication de demande de brevet français FR 2 874 340 décrit un moule carapace particulièrement adapté à la mise en oeuvre d'un procédé de fonderie avec solidification dirigée. Ce moule carapace de l'état de la technique comprend un fût central s'étendant, suivant un axe principal, entre un godet de coulée et une base, et une pluralité de cavités de moulage arrangées en grappe autour du fût central, chacune reliée au godet de coulée par un canal d'amenée. Afin de permettre une solidification dirigée du métal en fusion dans les cavités de moulage, chacune de celles-ci est aussi reliée par un sélecteur en chicane à un starter adjacent à la base. En outre, ce moule carapace comporte aussi au moins un écran thermique sensiblement perpendiculaire audit axe principal.

Dans un procédé de fonderie utilisant ce moule carapace, après la coulée du métal en fusion à travers le godet de coulée, ce métal en fusion est progressivement refroidi, suivant ledit axe principal à partir de la base vers le godet de coulée. Ceci peut être réalisé, par exemple, en extrayant progressivement le moule carapace d'une chambre de chauffage, suivant l'axe principal, en direction de la base, tout en refroidissant la base.

Grâce au refroidissement progressif du métal en fusion à partir du plateau, les premiers grains solides germent dans les starters adjacents au plateau. La configuration des sélecteurs en chicane empêche ensuite la propagation de plus d'un seul grain vers chaque cavité de moulage.

L'objet d'utiliser au moins un écran thermique est celui d'essayer d'assurer que le front de propagation de la cristallisation dans chaque cavité de moulage reste sensiblement perpendiculaire à l'axe principal. Une inclinaison du front de propagation risque en effet de causer la germination de grains parasites dans la cavité de moulage. Toutefois, il s'avère néanmoins difficile d'empêcher une telle inclinaison de manière générale, en particulier dans des cavités de moulage à forme complexe.

### Objet et résumé de l'invention

L'invention vise à résoudre ces inconvénients, et en particulier à proposer un moule carapace qui permette d'assurer une solidification dirigée du métal en fusion dans les cavités de moulage du moule carapace, et ceci de manière générale.

Dans au moins un mode de réalisation, ce but est atteint grâce au fait qu'au moins un écran thermique entoure complètement chacune des cavités de moulage dans un plan sensiblement perpendiculaire audit axe principal.

Grâce à ces dispositions, on peut obtenir des températures sensiblement homogènes sur le pourtour de chaque cavité de moulage dans chaque plan perpendiculaire à l'axe principal, contribuant ainsi à maintenir l'orientation du front de propagation de la cristallisation dans la cavité de moulage de manière à éviter la formation de grains parasites.

Afin de maintenir l'orientation du front de propagation dans chaque cavité de moulage, notamment lorsque celles-ci présentent une longueur relativement importante, le moule carapace peut comporter au moins deux écrans thermiques sensiblement perpendiculaires à ladite première direction, avec un écart entre eux dans ladite première direction, et chacun entourant complètement chacune desdites cavités dans un plan sensiblement perpendiculaire audit axe principal. Pour faciliter la production du moule carapace, ces écrans thermiques peuvent notamment être sensiblement identiques, c'est-à-dire suffisamment similaires pour être interchangeables.

L'au moins un écran thermique peut comporter des raidisseurs, afin de le soutenir dans la direction de l'axe principal du moule carapace. Pour accommoder les cavités de moulage, l'au moins un écran thermique peut présenter un orifice traversant autour de chaque cavité de moulage.

La base du moule carapace peut former un plateau pour assurer son soutien. , ainsi que pour offrir un bon contact thermique d'un métal coulé dans le moule carapace avec une sole refroidie sous le moule carapace. Ceci permettra ensuite le refroidissement du métal par le bas, pendant l'extraction du moule carapace d'une chambre de chauffage, afin d'assurer la solidification dirigée du métal en fusion dans le moule carapace. En outre, le moule carapace peut également comprendre des raidisseurs supplémentaires, reliant les cavités de moulage à un sommet du godet de coulée.

La présente invention concerne également un procédé de fabrication d'un tel moule carapace, et notamment un procédé comportant la réalisation d'une grappe non permanente comprenant une pluralité de modèles reliés par un arbre, le trempage de la grappe dans une barbotine, le saupoudrage de la grappe enduite de barbotine avec du sable réfractaire pour former une carapace autour de la grappe, l'évacuation de la grappe, et la cuisson de la carapace. Les étapes de trempage et saupoudrage peuvent être répétées plusieurs fois afin d'obtenir une épaisseur souhaitée de la carapace. L'évacuation de la grappe non permanente peut normalement être assurée par fusion du matériau de la grappe, dont la température de fusion serait comparativement peu élevée.

En particulier, afin de faciliter la formation de chaque écran thermique, chaque écran thermique peut être formé autour d'un disque non permanent, réalisé par exemple aussi en une matière à basse température de fusion, comme la grappe.

La présente invention concerne également un procédé de fonderie utilisant un tel moule carapace et comprenant une coulée de métal en fusion dans le moule carapace à travers le godet de coulée, et le refroidissement progressif du métal en fusion suivant ledit axe principal, à partir de la base vers le godet de coulée. En particulier, l'étape de refroidissement progressif du métal fondu est réalisée en extrayant progressivement le moule carapace d'une chambre de chauffage, suivant l'axe principal, en direction du plateau, tout en refroidissant sa base.

### Brève description des dessins

L'invention sera bien comprise et ses avantages apparaîtront mieux, à la lecture de la description détaillée qui suit, d'un mode de réalisation représenté à titre d'exemple non limitatif. La description se réfère aux dessins annexés sur lesquels :
- la figure 1 illustre schématiquement une étape de refroidissement progressif du métal en fusion dans un procédé de fonderie à solidification dirigée ;
- les figures 2A et 2B illustrent, respectivement, une progression souhaitable et une progression non souhaitable du front de propagation de la cristallisation du métal dans une cavité de moulage lors du refroidissement progressif de la figure 1 ;
- la figure 3 est une coupe longitudinale d'un moule carapace suivant un mode de réalisation de la présente invention ;
- la figure 4 est une vue latérale du moule carapace de la figure 3 ;
- la figure 5 est une vue en perspective d'un noyau non permanent destiné à former un écran thermique du moule carapace des figures 3 et 4 ; et
- la figure 6 est une vue en perspective d'une grappe non permanente servant à former le moule carapace des figures 3 et 4.

### Description détaillée de l'invention

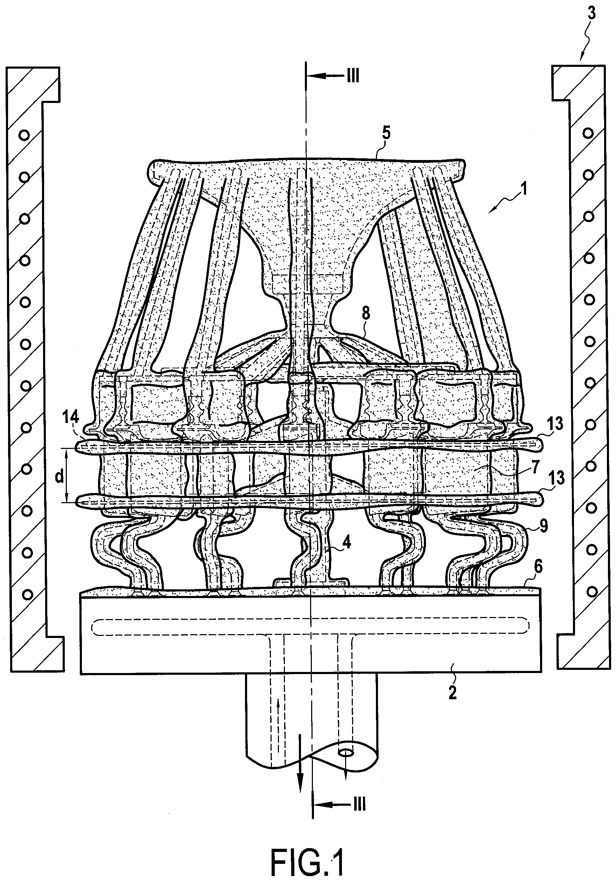

La figure 1 illustre comment un refroidissement progressif du métal en fusion destiné à obtenir une solidification dirigée peut typiquement être réalisé dans un procédé de fonderie. Dans cette étape de refroidissement progressif, subséquente à la coulée du métal en fusion dans un moule carapace 1, ce moule carapace 1, soutenu par un support 2 refroidi et mobile, est extrait d'une chambre de chauffage 3, suivant un axe principal X, vers le bas.

Le moule carapace 1 comporte un fût central 4 s'étendant, en direction de l'axe principal X, entre un godet de coulée 5 et une base 6 en forme de plateau. Pendant l'extraction du moule carapace 1 de la chambre de chauffage 3, cette base 6 est directement en contact avec le support 2. Le moule carapace 1 comprend aussi une pluralité de cavités de moulage 7 arrangées en grappe autour du fût central 4. Chaque cavité de moulage 7 est reliée au godet de coulée 5 par un canal d'amenée 8 à travers duquel le métal en fusion s'y est introduit lors de sa coulée. Chaque cavité de moulage 7 est aussi également reliée par le bas, à travers un sélecteur 9 en chicane, à un starter 10 formé par une plus petite cavité dans la base 6.

Le moule carapace 1 étant refroidi à travers de sa base 6 par le support 2, la solidification du métal en fusion va se déclencher dans les starters 10 et se propager vers le haut suite à l'extraction progressive du moule carapace 1 de la chambre de chauffage 3 par le bas. L'étranglement formé par chaque sélecteur 9, ainsi que sa forme en chicane, vont toutefois assurer qu'un seul grain, parmi ceux ayant initialement germiné dans chaque starter 10, va pouvoir continuer à s'étendre vers la cavité de moulage 7 correspondante.

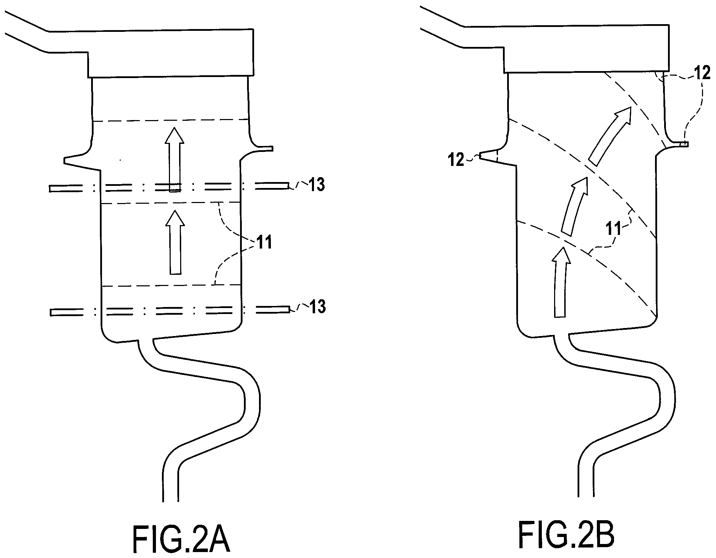

La figure 2A illustre la progression souhaitée du front de propagation 11 de la cristallisation du métal en fusion dans une cavité de moulage 7 en forme d'aube de turbomachine. Afin d'obtenir une aube de turbomachine monocristalline, on souhaite une progression régulière de cette cristallisation suivant l'axe principal de la cavité de moulage 7. Si, par contre, le front de propagation 11 s'incline lors de sa progression dans la cavité de moulage 7, comme illustré comparativement sur la figure 2B, le risque de génération de grains parasites 12 dans certains endroits de la cavité de moulage 7 augmente sensiblement. Or, des gradients de température perpendiculairement à l'axe principal de la cavité de moulage 7 peuvent facilement provoquer une telle inclinaison du front de propagation 11. Il est donc souhaitable de maîtriser en particulier le rayonnement thermique des différents éléments du moule carapace 1.

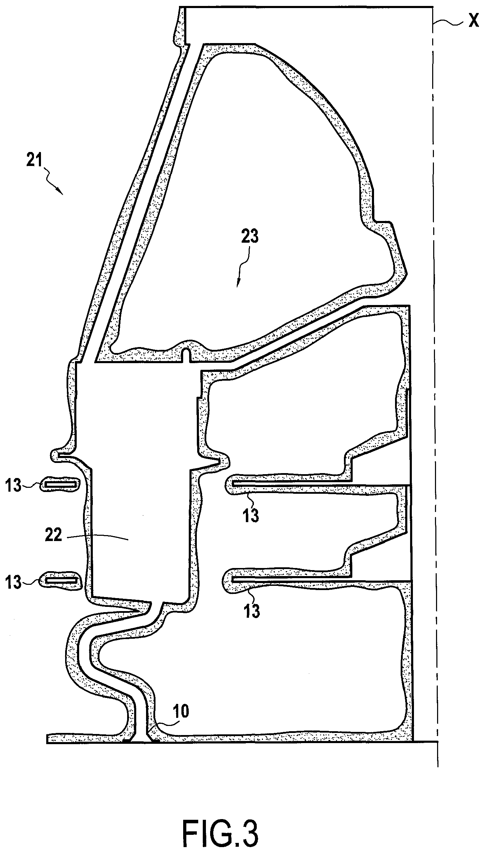

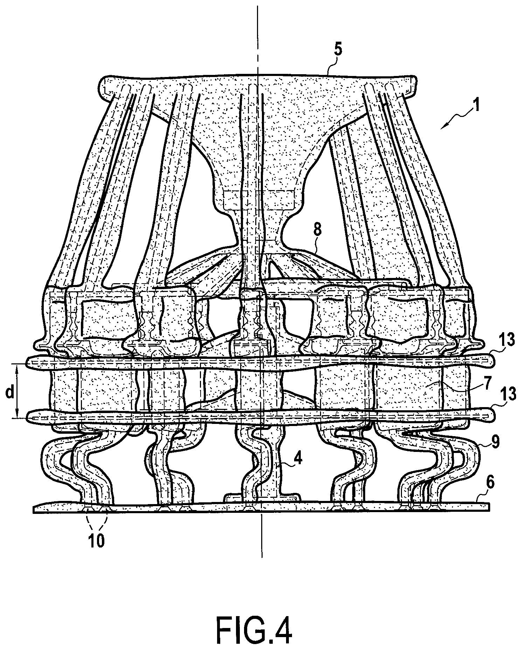

Les figures 3 et 4 illustrent un moule carapace 1 suivant un mode de réalisation de l'invention. Ce moule carapace 1 comprend deux écrans thermiques 13 s'étendant perpendiculairement à l'axe principal X à partir du fût central 4. Les deux écrans thermiques 13 sont situés, avec un écart longitudinal d en direction de l'axe principal X, à la hauteur des cavités de moulage 7. Le diamètre de chacun des deux écrans thermiques 13 est tel qu'ils s'étendent radialement au-delà des parois de chaque cavité de moulage 7. Ainsi, chaque écran thermique 13 entoure complètement chacune des cavités de moulage 7 dans un plan transversal perpendiculaire à l'axe principal X. Toutefois, afin d'empêcher la conduction directe de chaleur entre les parois de la cavité de moulage 7 et chaque écran thermique 13, un écart transversal peut séparer ces parois de chaque écran thermique 13 dans ce plan transversal tout autour de chaque cavité de moulage.

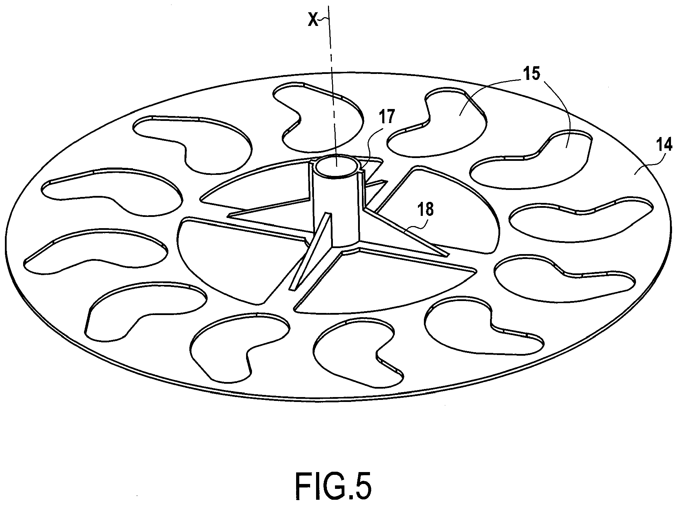

Dans le mode de réalisation illustré, chaque écran thermique 13 a été formé autour d'un disque 14 en cire, comme celui illustré sur la figure 5. Les deux disques 14 peuvent être sensiblement identiques. Le disque 14 illustré présente une pluralité d'orifices traversants 15 correspondant chacun à une cavité de moulage 7, un fût central avec un tenon 17 de positionnement et de maintien, et des voiles 18 s'étendant radialement, et perpendiculairement au plan transversal afin de former des raidisseurs pour assurer la rigidité de chaque écran thermique 13 dans la direction de l'axe principal X.

La base 6 du moule carapace 1 est en forme de plateau. En outre, des raidisseurs 20 en forme de colonnes inclinées relient le sommet de chaque cavité de moulage 7 à celui du godet de coulée 5.

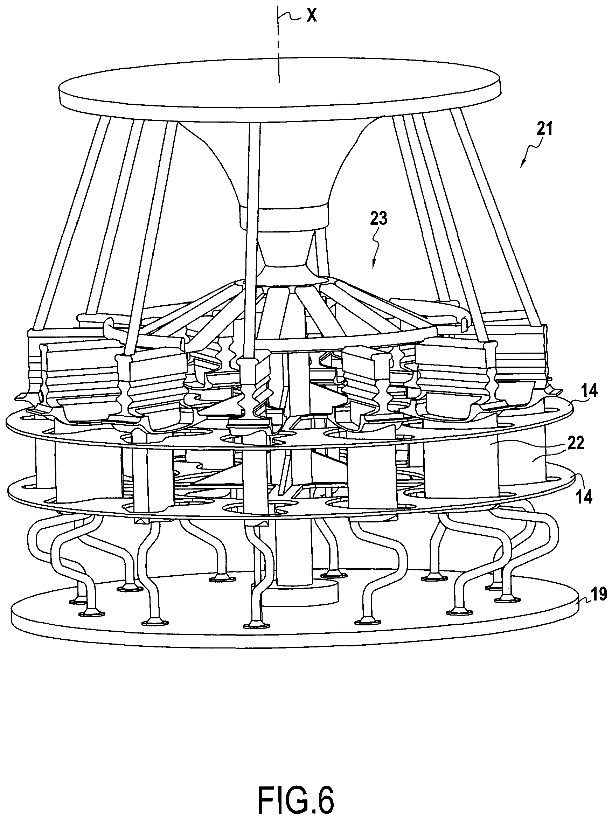

Le moule carapace 1 peut être produit par le procédé dit à cire perdue ou à modèle perdu. Une première étape d'un tel procédé est la création d'une grappe non permanente 21 comprenant une pluralité de modèles 22 reliés par un arbre 23, comme celle illustrée sur la figure 6. Les parties de l'arbre 23 destinées à former des volumes creux dans le moule carapace 1, comme notamment le godet de coulée 5, les canaux d'amenée 8, les raidisseurs 20, les sélecteurs 9 , les écrans thermiques 13, et les starters 10 sont formées en une matière à basse température de fusion, comme une cire ou résine de modelage. Les modèles 22, qui vont former les cavités de moulage 7, sont également formés en une matière à basse température de fusion. Lorsque la production de grands nombres de pièces est envisagée, il est notamment possible de produire ces éléments par injection de la cire ou résine de modelage dans un moule permanent. Grâce au tenon 17 de positionnement et de maintien, chaque disque 14 peut être correctement positionné, avec ses orifices 15 alignés avec les modèles 22.

Dans ce mode de réalisation, pour produire le moule carapace 1 à partir de cette grappe non permanente 21, on procède à tremper la grappe 21 dans une barbotine, pour ensuite la saupoudrer avec un sable réfractaire. Ces étapes de trempage et saupoudrage peuvent être répétées plusieurs fois, jusqu'à former une carapace de sable imprégné de barbotine d'une épaisseur souhaitée autour de la grappe 21.

La grappe 21 enrobée de cette carapace peut ensuite être chauffée pour faire fondre et évacuer de l'intérieur de la carapace la matière à basse température de fusion de la grappe 21. Ensuite, dans une étape de cuisson à plus haute température, la barbotine se solidifie de manière à consolider le sable réfractaire pour former le moule carapace 1 des figures 3 et 4.

Ce moule carapace 1 peut ensuite être utilisé dans un procédé de fonderie dans lequel du métal en fusion est d'abord coulé dans le moule carapace 1 à travers le godet de coulée 5, pour ensuite être sujet à une solidification dirigée de la manière illustrée sur la figure 1. Parmi les alliages métalliques pouvant être utilisés dans ce procédé, on compte notamment les alliages monocristallins de nickel, tels que, notamment, les AM1 et AM3 de SNECMA, mais aussi d'autres comme les CMSX-2®, CMSX-4®, CMSX-6®, et CMSX-10® du C-M Group, les René® N5 et N6 de General Electric, les RR2000 et SRR99 de Rolls-Royce, et les PWA 1480, 1484 et 1487 de Pratt & Whitney, entre autres. Le tableau 1 illustre les compositions de ces alliages :

**Tableau 1 : Compositions d'alliages de nickel monocristallins en % massique**

| Alliage | Cr | Co | Mo | W | AI | Ti | Ta | Nb | Re | Hf | C | B | Ni |
|---|---|---|---|---|---|---|---|---|---|---|---|---|---|
| CMSX-2 | 8,0 | 5,0 | 0,6 | 8,0 | 5,6 | 1,0 | 6,0 | - | - | - | - | - | Bal |
| CMSX-4 | 6,5 | 9,6 | 0,6 | 6,4 | 5,6 | 1,0 | 6,5 | - | 3,0 | 0,1 | - | - | Bal |
| CMSX-6 | 10,0 | 5,0 | 3,0 | - | 4,8 | 4,7 | 6,0 | - | - | 0,1 | - | - | Bal |
| CMSX-10 | 2,0 | 3,0 | 0,4 | 5,0 | 5,7 | 0,2 | 8,0 | - | 6,0 | 0,03 | - | - | Bal |
| René N5 | 7,0 | 8,0 | 2,0 | 5,0 | 6,2 | - 7,0 | 7,0 | - | 3,0 | 0,2 | - | - | Bal |
| René N6 | 4,2 | 12,5 | 1,4 | 6,0 | 5,75 | - | 7,2 | - | 5,4 | 0,15 | 0,05 | 0,004 | Bal |
| RR2000 | 10,0 | 15,0 | 3,0 | - | 5,5 | 4,0 | - | - | - | - | - | - | Bal |
| SRR99 | 8,0 | 5,0 | - | 10,0 | 5,5 | 2,2 | 12,0 | - | - | - | - | - | Bal |
| PWA1480 | 10,0 | 5,0 | - | 4,0 | 5,0 | 1,5 | 12,0 | - | - | - | 0,07 | - | Bal |
| PWA1484 | 5,0 | 10,0 | 2,0 | 6,0 | 5,6 | - | 9,0 | - | 3,0 | 0,1 | - | - | Bal |
| PWA1487 | 5,0 | 10,0 | 1,9 | 5,9 | 5,6 | - | 8,4 | - | 3,0 | 0,25 | - | - | Bal |
| AM1 | 7,0 | 8,0 | 2,0 | 5,0 | 5,0 | 1,8 | 8,0 | 1,0 | - | - | - | - | Bal |
| AM3 | 8,0 | 5,5 | 2,25 | 5,0 | 6,0 | 2,0 | 3,5 | - | - | - | - | - | Bal |

Après le refroidissement et la solidification du métal dans le moule carapace 1, celui-ci pourra être décoché pour libérer les pièces métalliques, lesquelles pourront ensuite être finies par des procédés d'usinage et/ou des traitements de surface.

Quoique la présente invention ait été décrite en se référant à un exemple de réalisation spécifique, il est évident que des différentes modifications et changements peuvent être effectués sur cet exemple sans sortir de la portée générale de l'invention telle que définie par les revendications. Par conséquent, la description et les dessins doivent être considérés dans un sens illustratif plutôt que restrictif.

## Revendications

1. Moule carapace (1) comportant :
un fût central (4) s'étendant, suivant un axe principal (X), entre un godet de coulée (5) et une base (6) ;
une pluralité de cavités de moulage (7) arrangées en grappe autour du fût central (4), chacune étant reliée au godet de coulée (5) par au moins un canal d'amenée (8), et par un sélecteur (9) en chicane à un starter (10) dans la base (6) ; et
au moins un écran thermique (13) sensiblement perpendiculaire audit axe principal (X) ;
le moule carapace (1) étant **caractérisé en ce que** ledit au moins un écran thermique (13) entoure complètement chacune desdites cavités de moulage (7) dans un plan sensiblement perpendiculaire audit axe principal (X).

2. Moule carapace (1) suivant la revendication 1, comportant au moins deux écrans thermiques (13) sensiblement perpendiculaires à ladite première direction, avec un écart entre eux dans la direction dudit axe principal (X), et chacun entourant complètement chacune desdites cavités de moulage (7) dans un plan sensiblement perpendiculaire audit axe principal (X).

3. Moule carapace (1) suivant l'une quelconque des revendications 1 ou 2, dans lequel l'au moins un écran thermique (13) comprend des raidisseurs (18).

4. Moule carapace (1) suivant l'une quelconque des revendications 1 à 3, dans lequel l'au moins un écran thermique (13) présente un orifice traversant (15) autour de chaque cavité de moulage (7).

5. Procédé de fabrication d'un moule carapace (1) suivant l'une quelconque des revendications précédentes, comprenant les étapes suivantes :
réalisation d'une grappe non permanente (21) comprenant une pluralité de modèles (22) reliés par un arbre (23) ;
trempage de la grappe (21) dans une barbotine ;
saupoudrage de la grappe (21) enduite de barbotine avec du sable réfractaire pour former une carapace autour de la grappe (21) ;
évacuation de la grappe (21) ; et
cuisson de la carapace.

6. Procédé de fabrication d'un moule carapace (1) suivant la revendication 5, dans lequel chaque écran thermique (13) est formé autour d'un disque (14) non permanent.

7. Procédé de fonderie utilisant un moule carapace (1) suivant l'une quelconque des revendications 1 à 4, comprenant les étapes suivantes :
coulée de métal en fusion dans le moule carapace (1) à travers le godet de coulée (5) ; et
refroidissement progressif du métal en fusion suivant ledit axe principal (X), à partir de la base (6) vers le godet de coulée (5).

8. Procédé suivant la revendication 7, dans lequel l'étape de refroidissement progressif du métal fondu est réalisée en extrayant progressivement le moule carapace (1) d'une chambre de chauffage (2), suivant l'axe principal (X), en direction de la base (6), tout en refroidissant la base (6).

## Patentansprüche

1. Hüllenform (1) umfassend:
einen zentralen Schaft (4), der sich gemäß einer Hauptachse (X) zwischen einem Eingusstopf (5) und einer Basis (6) erstreckt,
eine Vielzahl von Formhohlräumen (7), die traubenförmig um den zentralen Schaft (4) angeordnet sind, wobei jeder mit dem Eingusstopf (5) durch mindestens einen Zufuhrkanal (8) und durch ein Auswahllabyrinth (9) mit einem Starter (10) in der Basis (6) verbunden ist, und
mindestens einen zur Hauptachse (X) etwa senkrechten Hitzeschild (13),
wobei die Hüllenform (1) **dadurch gekennzeichnet ist, dass** der mindestens eine Hitzeschild (13) jeden der Formhohlräume (7) in einer zur Hauptachse (X) etwa senkrechten Ebene vollständig umgibt.

2. Hüllenform (1) nach Anspruch 1, die mindestens zwei zu der ersten Richtung etwa senkrechte Hitzeschilde (13) mit einem Abstand untereinander in Richtung der Hauptachse (X) aufweist, und wobei jeder jeden der Formhohlräume (7) in einer zur Hauptachse (X) etwa senkrechten Richtung vollständig umgibt.

3. Hüllenform (1) nach einem der Ansprüche 1 oder 2, wobei der mindestens eine Hitzeschild (13) Versteifungen (18) umfasst.

4. Hüllenform (1) nach einem der Ansprüche 1 bis 3, wobei der mindestens eine Hitzeschild (13) eine Durchgangsöffnung (15) um jeden Formhohlraum (7) umfasst.

5. Verfahren zur Herstellung einer Hüllenform (1) nach einem der vorangehenden Ansprüche, umfassend die folgenden Schritte:
Herstellen einer nicht permanenten Traube (21), umfassend eine Vielzahl von Modellen (22), die durch einen Baum (23) verbunden sind,
Eintauchen der Traube (21) in einen Schlicker,
Bestäuben der mit Schlicker beschichteten Traube (21) mit hitzefestem Sand, um eine Hülle um die Traube (21) zu bilden,
Entnehmen der Traube (21), und
Brennen der Hülle.

6. Verfahren zur Herstellung einer Hüllenform (1) nach Anspruch 5, wobei jeder Hitzeschild (13) um eine nicht permanente Scheibe (14) gebildet ist.

7. Gussverfahren, das eine Hüllenform (1) nach einem der Ansprüche 1 bis 4 verwendet, umfassend die folgenden Schritte:
Gießen des geschmolzenen Metalls durch den Eingusstopf (5) in die Hüllenform (1), und
allmähliches Abkühlen des geschmolzenen Metalls gemäß der Hauptachse (X) ab der Basis (6) zum Eingusstopf (5).

8. Verfahren nach Anspruch 7, wobei der Schritt des allmählichen Abkühlens des geschmolzenen Metalls durchgeführt wird, indem die Hüllenform (1) einer Heizkammer (2) gemäß der Hauptachse (X) in Richtung der Basis (6) bei Kühlung der Basis (6) allmählich entnommen wird.

## Claims

1. A shell mold (1) comprising:
• central cylinder (4) extending, along a main axis (X), between a casting cup (5) and a base (6);
• a plurality of molding cavities (7) arranged as a cluster around the central cylinder (4), each one being connected to the casting cup (5) by at least a feed channel (8), and via a baffle-selector (9) to a starter (10) in the base (6); and
• at least one heat shield (13) that is substantially perpendicular to said main axis (X);
the shell mold (1) being **characterized in that** said at least one heat shield (13) completely surrounds each said molding cavity (7) in a plane that is substantially perpendicular to said main axis (X).

2. A shell mold (1) according to claim 1, comprising at least two heat shields (13) that are substantially perpendicular to said first direction, with an offset between them in the direction of said main axis (X), and each completely surrounding each said molding cavity (7) in a plane that is substantially perpendicular to said main axis (X).

3. A shell mold (1) according to claim 1 or claim 2, wherein at least one heat shield (13) includes stiffeners (18).

4. A shell mold (1) according to any one of claims 1 to 3, wherein at least one heat shield (13) presents a through orifice (15) around each molding cavity.

5. A method of fabricating a shell mold (1) according to any preceding claim, comprising the following steps:
• making a non-permanent cluster (21) comprising a plurality of models (22) connected by a tree (23);
• dipping the cluster (21) in a slip;
• dusting the slip-coated cluster (21) with refractory sand in order to form a shell around the assembly (21);
• removing the cluster (21); and
• baking the shell.

6. A method of fabricating a shell mold (1) in accordance with claim 5, wherein each heat shield (13) is formed around a non-permanent disk (14).

7. A casting method using a shell mold (1) according to any one of claims 1 to 4, comprising the following steps:
• casting molten metal into the shell mold (1) through the casting cup (5); and
• progressively cooling the molten metal along said main axis (X), from the base (6) towards the casting cup (5).

8. A method according to claim 7, wherein the step of progressively cooling the molten metal is performed by gradually extracting the shell mold (1) from a heater chamber (2), along the main axis (X), in the direction of the base (6), while cooling the base (6).
